# EUROPEAN PATENT APPLICATION

(11) **EP 1 175 965 A2**
(43) Date of publication of application: **30.01.2002**
(21) Application number: 01118039.5
(22) Date of filing: 25.07.2001
(51) Int. Cl.: B24D 3/00, B24D 18/00, B24B 37/04, B24B 7/22, B24B 1/00, H01L 21/306

(54) **Polishing tool, manufacturing method therefor, polishing apparatus for polishing a semiconductor wafer and method of polishing a substrate**

(30) Priority: 25.07.2000 JP 2000224485; 18.01.2001 JP 2001010830; 23.04.2001 JP 2001125010
(71) Applicant: EBARA CORPORATION, Ohta-ku, Tokyo (JP)
(72) Inventor: Hirokawa, Kazuto, c/o Ebara Corporation, Tokyo (JP); Hiyama, Hirokuni, c/o Ebara Research Co., Ltd., Fujisawa-shi, Kanagawa-ken (JP); Matsuo, Hisanori, c/o Ebara Corporation, Tokyo (JP); Wada, Yutaka, c/o Ebara Corporation, Tokyo (JP)
(74) Representative: Wagner, Karl H., Dipl.-Ing.

(57) **Abstract**

A polishing tool (1) applicable to various types of polishing objects is provided that enables to stabilize the polishing speed and to obtain superior surface details while reducing the formation of defects such as scratches on the polished surface. The tool is operated by pressing and sliding on the polishing object in a swinging motion and the surface is polished with abrasive particles (5) imbedded in a matrix (4) comprised primarily of a thermoplastic resin such as butadiene styrene, polybutadiene or MBS resin of acryl rubber group. The polishing tool includes fixed-abrasive polishing tool that contains abrasive particles within the polishing tool, or a polishing pad containing non-fixed-abrasive particles.
Moreover, methods for making a fixed-abrasive polishing tool, apparatus for polishing a semiconductor wafer and a method of polishing a substrate are provided.

## Description

### BACKGROUND OF THE INVENTION

### Field of the Invention:

The present invention relates to a polishing tool and its manufacturing method, and relates in particular to the structure of a fixed-abrasive polishing tool or a polishing pad, used to polish a polishing object such as semiconductor wafers to a flat and mirror polished surface.

### Description of the Related Art:

In recent years, as semiconductor devices become more highly integrated, the line width of the circuit is becoming finer and the dimensions of the integrated devices are becoming finer. In the process of manufacturing such devices, there is sometimes a need to remove a film formed on the surface of a semiconductor wafer by polishing so as to planarize the surface, and as a means for such planarization, chemical mechanical polishing (CMP) is used. The CMP apparatus of this type has a turntable with a bonded polishing pad and a topring, and a polishing object is placed between the turntable and the topring so that both the turntable and the topring can be rotated while the topring exerts a certain pressure on the turntable and a slurry is delivered on the polishing pad to polish the surface of the polishing object flat and in a mirror polish.

In the CMP method based on the slurry, there is a problem that the quality of polish depends on the device pattern, because polishing is performed using a relatively soft polishing pad while supplying a slurry containing a large quantity of abrasive particles. Pattern-dependency means that because the semiconductor wafer has patterns comprised by high portions and low portions before it is planarized, the polished surface exhibits mild slopes even after polishing such that a perfectly flat surface is difficult to obtain. This is caused by the fact that polishing speed is fast in regions of finely spaced patterns but the polishing speed is slow in regions of coarsely spaced patterns, thereby producing mild slopes between the regions of slow and fast polishing speeds. And, in the technique based on the polishing pad, not only the high portions but also the low portions are polished so that it has been difficult to realize the so-called self-stopping function in this type of operation, which stops the polishing automatically when the high portions are completely removed.

On the other hand, there has been much study on the technique of polishing based on the so-called fixed-abrasive polishing tool in which abrasive particles such as cerium oxide are fixated using a binder such as phenolic resin. In the technique based on fixed-abrasive polishing tool, because the polishing materials are harder than the materials used in the conventional CMP methods, high portions are more readily removed compared with the low portions, leading to an advantage that an absolute flatness is more easily obtained using this technique. Also, depending on the choice of the composition of the fixed-abrasive polishing tool, the self-stopping function can be made to operate, in which the speed of polishing becomes extremely low when the high portions are removed so that the polishing operation virtually ceases. Also, in the technique based on fixed-abrasive polishing tool, because slurry containing a large amount of abrasive particles is not used, there is an advantage that the technique is environmentally friendly.

However, in the technique based on fixed-abrasive polishing tool, the following problems have been noted. That is, when making semiconductor devices, the polished surface after the CMP processing not only must be flat but must also avoid creating scratches (damage) on the surface. When a polishing pad for CMP processing is used in polishing an object, it is known that, when the hardness of the pad is high, the polished surface is vulnerable to creating scratches, and for this reason, soft materials are used generally for making pads, and to achieve this end, soft foaming agents are used in making the pads. On the other hand, using the fixed-abrasive polishing tools, because the fixed-abrasive polishing tools are harder than pad materials, many scratches are created on the polished surface even though high flatness is achieved.

Therefore, fixed-abrasive polishing tools for semiconductor device processing have been used with considerable restrictions, such as the type of binder or a narrow range of compositions in which the abrasive particles, binder and porosity have been optimized. In the meantime, the polishing objects range widely from silicon substrate, polysilicon films, oxide films, nitride films to wiring layers comprised by aluminum or copper. For these reasons, it has been difficult in reality to manufacture fixed-abrasive polishing tools that can produce stable polishing speed and retain differences in the pattern level as well as refraining from causing scratches on the polished surface.

### SUMMARY OF THE INVENTION

The present invention is provided in view of the background information described above, and an object is to provide a polishing tool and a method of manufacturing the polishing tool that exhibits a stable speed of polishing and good surface flatness and is able to reduce various defects such as scratches created on the polished surface of a polishing object of various types.

First aspect of the invention relates to a polishing tool that polishes an object using a sliding motion while pressing on the object by abrasive particles, wherein the polishing tool is comprised primarily by a thermoplastic resin.

Second aspect relates to a polishing tool that polishes an object using a sliding motion while pressing on the object by abrasive particles, wherein the polishing tool is comprised by a polymer resin to provide a hard matrix and elastic elements having elastic properties contained in the matrix.

Third aspect relates to a polishing tool, wherein the polishing tool is a fixed-abrasive polishing tool that contains abrasive particles within the tool.

Fourth aspect relates to a polishing tool, wherein the polishing tool is a polishing pad.

Conventional fixed-abrasive polishing tool for semiconductor wafers is based generally on the use of a thermosetting resin such as PVA, phenolic resin, or epoxy resin. In the present invention, instead of thermosetting resin, thermoplastic resin is used, and elastic bodies (polymer substance) are dispersed within a hard resin matrix, thereby producing a fixed-abrasive polishing tool having unique properties that could not be obtained in conventional fixed-abrasive polishing tools. That is, heat is generated during polishing of wafers so that, by using a thermoplastic resin in a fixed-abrasive polishing tool or polishing pad, the generated heat tends to soften the resin. It enables to polish an object using a softer abrading surface, thus suppressing the formation of scratches (damage) on the polished surface. Also, by using a hard resin matrix containing elastic bodies within, the abrading surface is hard macroscopically but is soft microscopically, thus enabling to produce a polished surface of superior flatness as well as having less scratches.

Fifth aspect relates to the polishing tool, wherein the abrasive particles include cerium oxide (CeO₂), alumina (Al₂O₃), silicon carbide (SiC), silicon dioxide (SiO₂), zirconia (ZrO₂), iron oxides (FeO, Fe₃O₄), manganese oxide (MnO₂, Mn₂O₃), magnesium oxide (MgO), calcium oxide (CaO), barium oxide (BaO), zinc oxide (ZnO), barium carbonate (BaCO₃), calcium carbonate (CaCO₃), diamond (C), or a composite material comprised by those recited above.

Accordingly, using relatively readily available materials, a polishing tool is provided that enables a stable polishing speed with a flat finished surface and create less scratches (damage).

Sixth aspect relates to a polishing tool, wherein the polishing tool is formed by injection molding to charge a feed material under pressure into a mold of a specific shape. Injection molding is a process in which a molten feed material is injected under pressure into a cavity of a metal mold to replicate a solid product of a conjugate shape to the shape of the cavity. Accordingly, fixed-abrasive polishing tools can be produced readily at high productivity.

Seven aspect relates to a polishing tool, wherein the resin includes an acryronitrile butadiene styrene resin (known as ABS resin). ABS resin is a copolymer of acryronitrile, butadiene and styrene. The structure is comprised by small soft particles of butadiene rubber nuclei in a hard matrix of AS (acrylonitrile styrene) resin. A fixed-abrasive polishing tool comprised by ABS resin is as hard as AS resin from a macroscopic viewpoint so as to produce high planar surface by polishing on the object, but from a microscopic viewpoint, shock absorbing action is provided by the soft butadiene rubber to lead to suppression of scratches (damage) to enable high quality polishing. A polishing pad comprised by ABS resin has an abrading surface that is as hard as AS resin macroscopically, but microscopically, soft butadiene rubber particles provide shock absorbing action so that high quality polishing is enabled.

Eighth aspect relates to a polishing tool, wherein the resin includes a core-shell structure type resin having a core made of an elastic body containing a rubber material. It is preferable that the resin is a butadiene styrene, polybutadiene or acrylic rubber group MBS resin. Use of this resin for making a fixed-abrasive polishing tool enables highspeed polishing, same as in the case of ABS resin, and the polishing tool is able to produce extremely low number of scratches. Other than ABS, MBS resins, resins having a core-shell structure comprised by a core of an elastic body are similarly effective.

Tenth aspect relates to a polishing tool, wherein the elastic body includes an elastic filler material and the elastic filler material includes a rubber filler material. In so doing, by including small and soft rubber particles as a constituting element, similar effects to ABS resin is obtained such that the tool acts macroscopically hard, but microscopically the tool act softly on the polishing surface to enable high quality polishing. Therefore, even when the tool is used in conjunction with the slurry polishing technique, less scratches are created and high quality polishing is enabled.

Eleventh aspect relates to a polishing tool, wherein a material comprising the polishing tool further comprises a surface-active agent. Generally, polymeric materials (resins) have poor wettability with abrasive particles, and therefore, when a polishing is made using abrasive particles and binder only, there is a problem that abrasive particles do not disperse uniformly and large clusters are formed within the matrix. Extremely small clusters of particles fall off from the tool during polishing, and it is known that polishing byproducts and debris are trapped in the cavities thus generated so as to enable effective polishing action. However, clusters of the order of several hundred nanometers are detached from the matrix, immediately resulting in severe degradation of polishing capability with time and immediate loss of polishing capability. Further, differences of polishing ability appear within the polishing surface of the tool and leads to polishing problems such as non-uniformity of surface finish. Therefore, when a surface-active agent is added during kneading of raw material, wettability of the binder with abrasive particles is assured to produce a fixed-abrasive polishing tool that enables stable polishing.

Twelfth aspect relates to a polishing tool, wherein a material comprising the polishing tool further comprises a hydrophilic substance. Generally, polymeric materials are hydrophobic and rejects wetting by a polishing solution so that solution retaining ability of the polishing pad is low and stable polishing is difficult. Therefore, by including hydrophilic material having a large number of hydrophilic bases on its surface, wettability is assured so that the polishing surface of a polishing pad can retain the polishing solution uniformly throughout the polishing surface, and stable polishing is enabled.

Thirteenth aspect relates to a polishing tool, wherein a hydrophilic base is further added to modify a material comprising the polishing tool. Similar to the advantage recited in aspect twelve, the polishing solution can be retained on the polishing surface of the tool uniformly throughout to enable stable polishing.

Fourteenth aspect relates to a fixed-abrasive polishing tool that uses a sliding motion to polish an object while pressing on the object by abrasive particles, wherein the polishing tool includes a resin containing butadienestyrene group MBS resin, polybutadiene group MBS resin or an acrylic rubber group MBS resin.

MBS resin is a copolymer based on feed materials of methylmethacrylate and butadiene styrene, so as to form a core-shell type structure having a core of rubber layer comprised by a copolymer (SBR) containing butadiene and styrene, and a shell of a copolymer (MS) containing methylmethacrylate and styrene. Other than the copolymer (SBR) of butadiene and styrene, MBS resin comprising polybutadiene group rubber and polyacrylic ester group rubber may be used.

The copolymer (MS) of methylmethacrylate and styrene used for forming the shell structure of MBS resin can be softened by polymerizing polymethylmethacrylate (PMMA) adding styrene. Polymethylmethacrylate (PMMA) has a high hardness relative to other plastics and is characterized by its high hardness but suffers from brittleness, and such characteristics are known to be suitable for making fixed-abrasive polishing tools. Especially, this resin is effective for improving scratching property. Further, it is considered that, by mixing styrene to this material (methylmethacrylate) for polymerizing, hardness can be lowered and brittleness can be controlled, and the material cost can be reduced. MBS resin combining the shell of this material and rubber layer core has improved shock absorbing quality and is able to moderate the impact of abrasive particles generated when using the fixed-abrasive polishing tool. The tool therefore enables high quality polishing that produces scratch-free polished surface.

Fifteenth aspect relates to a method for making a fixed-abrasive polishing tool using abrasive particles and a thermoplastic resin as raw materials, by filling a mixture of the feed materials into a forming fixture followed by heating-cooling and/or a pressing process. In this process, cooling process includes self-cooling.

Sixteenth aspect relates to a method for making a fixed-abrasive polishing tool using abrasive particles and a thermoplastic resin as raw materials, by mixing the abrasive particles and the thermoplastic resin, prior to or during filling or after filling the feed materials into a forming fixture.

Seventeenth aspect relates to a method for making a fixed-abrasive polishing tool using abrasive particles and a thermoplastic resin as raw materials, by mixing abrasive particles or a slurry in which abrasive particles are dispersed in a liquid and raw materials for the thermoplastic resin to form a dispersion liquid, and making a polymerized mixture containing the thermoplastic resin and abrasive particles in the dispersion liquid, during the step of polymerizing or manufacturing the thermoplastic resin.

Methods for producing particles of a thermoplastic resin include a suspension polymerization and emulsion polymerization. According to these methods, spherical polymerized product can be produced in a dispersion liquid of the raw material (monomer) of a thermoplastic resin. By mixing abrasive particles or a slurry (particle dispersion liquid) in such a dispersion liquid, a mixture of abrasive particles and resin can be obtained during the polymerizing step.

Eighteenth aspect relates to a method for making a fixed-abrasive polishing tool using abrasive particles and a thermoplastic resin as raw materials, making a dispersion liquid by mixing abrasive particles or a slurry and raw materials for the thermoplastic resin, making a polymerized mixture of the thermoplastic resin and abrasive particles in the dispersion liquid, and performing a spray drying or other mist drying process.

Methods for producing particles of a thermoplastic resin include a suspension polymerization and emulsion polymerization. According to these methods, spherical polymerized product can be produced in a dispersion liquid of the raw material (monomer) of a thermoplastic resin. By mixing abrasive particles or a slurry (particle dispersion liquid) in the above dispersion liquid, a mixture of abrasive particles and resin can be obtained during the polymerizing step. By drying and particulating the microparticles of the mixed material, suitable sizes of the feed material for making the fixed-abrasive polishing tool can be obtained. Further, it enables to improve the uniformity of distribution of microparticles of abrasive particles and the resin.

Nineteenth aspect relates to a method for making a fixed-abrasive polishing tool using abrasive particles and a thermoplastic resin as raw materials, wherein during polymerizing or manufacturing of the thermoplastic resin, a polymerized mixture containing the thermoplastic resin and abrasive particles of particle diameter in a range of 1-500 µm is obtained.

Methods for producing particles of a thermoplastic resin include a suspension polymerization and emulsion polymerization. According to these methods, spherical polymerized product can be produced in a dispersion liquid of the raw material (monomer) of a thermoplastic resin. By mixing abrasive particles or a slurry (particle dispersion liquid) in such a dispersion liquid, a mixture of abrasive particles and resin can be obtained during the polymerizing step. Further, by obtaining a particle size in a range of 1-500 µm, which is suitable for making the fixed-abrasive polishing tool, during the step of obtaining the mixture particles, the feed material for making a fixed-abrasive polishing tool can be obtained simply by drying.

Twentieth aspect relates to the method for making a fixed-abrasive polishing tool using abrasive particles and a thermoplastic resin as raw materials, by mixing/dispersing a powder of abrasive particles or a slurry and a powder of the thermoplastic resin or an emulsion in a liquid, such as water or a solvent, and subjecting a resulting liquid to a drying and comminuting process, before filling into a forming fixture.

Twenty-first aspect relates to the method for making a fixed-abrasive polishing tool using abrasive particles and a thermoplastic resin as raw materials, by drying the powder of abrasive particles or a slurry, mixing/dispersing an emulsion of a resulting dried substance and the thermoplastic resin, and subjecting a resulting liquid to a drying and comminuting process, before filling into a forming fixture.

Twenty-second aspect relates to the method for making a fixed-abrasive polishing tool using abrasive particles and a thermoplastic resin as raw materials, by drying the powder of abrasive particles or a slurry, dispersing a resulting dried substance and a dried product of the thermoplastic resin in a liquid, such as water or a solvent, and subjecting a resulting liquid to a drying and comminuting process, before filling into a forming fixture.

Twenty-third aspect relates to the method for making a fixed-abrasive polishing tool using a liquid feed material containing abrasive particles and a thermoplastic resin, by applying mist drying during a process of drying the liquid feed material before filling into a forming fixture.

Twenty-fourth aspect relates to the method for making a fixed-abrasive polishing tool using abrasive particles and a thermoplastic resin as raw materials, during drying of a mixed matter of a fixed-abrasive polishing tool or after drying, pulverizing to obtain a powder in a range of 1-500 µm.

Twenty-fifth aspects relates to a semiconductor wafer polishing apparatus having a polishing tool recited above.

Twenty-sixth aspects relates to a method for polishing a semiconductor wafer using a polishing tool recited above.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

FIGS. 1A, 1B are schematic diagrams of the fixed-abrasive polishing tools to show a tool made with a thermoplastic resin in FIG. 1A, and a tool containing an elastic filler in FIG. 1B;
FIG. 2 is a diagram to explain injection molding;
FIGS. 3A, 3B are schematic diagrams of structures of polishing pads.
FIG 4 is a comparison of experimental data of (a) polishing speed and (b) amount of defects produced by fixed-abrasives made with various resin materials;
FIG. 5 is a comparison of experimental data of (a) polishing speed and (b) amount of defects produced by a polishing pad containing no abrasive particles;
FIG. 6 is a diagram to show an example of making particles using a spray dryer according to a spray drying method;
FIGS. 7A⁻7C are diagrams for explaining a method of manufacturing a fixed-abrasive polishing tool by hot pressing;
FIG. 8 is an overall plan view of the polishing facility;
FIGS. 9A, 9B are a plan view and a cross sectional view of some key sections of a polishing apparatus;
FIG. 10 is diagram to show a clamping method of attaching a fixed-abrasive polishing tool to the fixed disk;
FIG. 11 is a diagram to show another method of attaching a fixed-abrasive polishing tool to the fixed disk; and
FIG. 12 is a schematic diagram to show an example of the structure of a polishing apparatus based on polishing slurry;
FIG. 13 is a diagram to show another embodiment of the polishing apparatus of the present invention.

### DETAILED DESCRIPTION OF THE PREFERRED EMBODIMENTS

In the following, preferred embodiments will be explained with reference to the drawings.

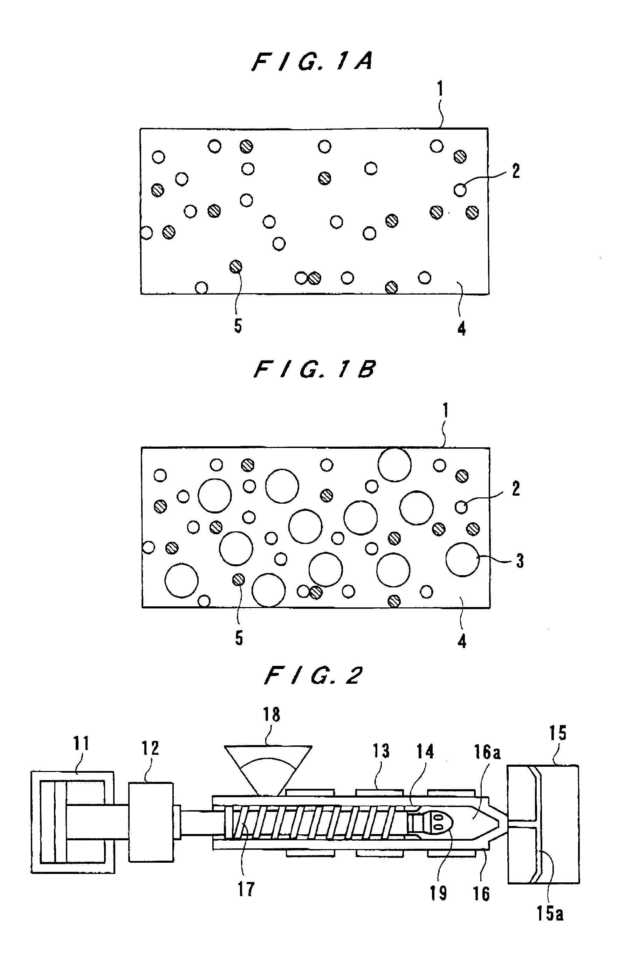

FIGS 1A and 1B are schematic diagrams of a fixed-abrasive polishing tool of the present invention. The fixed-abrasive polishing tool 1 shown in FIG. 1A is comprised by the abrasive particles 5 and porosity or foaming agent 2 with a binder (resin) 4. Here, the binder 4 comprises a thermoplastic resin such as ABS resin. When such a thermoplastic resin is heated, the binder becomes soft and exhibits elasticity and acts in a manner similar to rubber type resins, and is able to reduce damage on the polished surface such as scratches by contacting the polishing surface of a polishing object softly during polishing operation. The tool 1 shown in FIG. 1B is comprised by abrasive particles 5, an elastic filler material 3 such as rubber type particles and porosity or a foaming agent 2 using a binder (resin). Here, a hard resin is used as the binder 4. The elastic filler material 3 acts in a similar manner to rubber type particles, and is able to reduce damage such as scratches by contacting the polishing surface of a polishing object softly during polishing operation.

Conventional fixed-abrasive polishing tools are generally made by compression forming of a binder feed mixture containing abrasive particles. In contrast, the present polishing tool features the use of a thermoplastic material, and accordingly, a mass production technique such as injection molding, blow forming and vacuum forming can be used. Because thermoplastic resins are characterized by its melting behavior when heated to a temperature beyond a certain temperature, so that it enables to manufacture various fixed-abrasive polishing tools having characteristics that have not been demonstrated to date, and enables to manufacture fixed-abrasive polishing tools having properties that are suitable for application to various polishing objects. By choosing a fixed-abrasive polishing tool having an appropriate thermoplastic resin as its primary component, it is considered that elevated temperature produced during polishing is localized, and the abrading surface of the fixed-abrasive polishing tool is made soft and pliable. Thus, the surface being polished is under a stable pressing pressure and excessive force is not applied to the abrasive particles. In other words, abrasive particles which exist on the surface being polished are being compressed with a softer tool to enable to reduce scratching (damage) the polishing surface of the polishing object.

In the present invention, the resin to serve as the binder for fixating the particles of the fixed abrasive polishing tool is comprised primarily of thermoplastic resins. Although it is permissible to use 100 % thermoplastic resin as the binder resin, it is permissible to use a thermoplastic resin for not less than 90 % of the binder and the remainder may be made of a thermosetting resin.

In the following, examples of the materials for comprising thermosetting resins and thermoplastic resins are shown. Thermosetting resins include phenol (PF), urea (UF), melamine (MF), unsaturated polyester (UP), epoxy (EP), silicone (SI), polyurethane (PUR) and the like, and these substances are hardened by adding a third substance. And, thermoplastic resins include polyvinyl chloride (PVC) known as general purpose plastic, polyethylene (PE), polypropylene (PP), polystyrene (PS), acrylonitrile butadiene styrene (ABS), butadiene styrene, polybutadiene, or acrylic rubber group MBS resin (methylmethacrylate butadiene styrene (MBS)), a copolymer resin of styrene monomer and acrylonitrile (AS, SAN), polymethylmethacrylate (PMMA), a copolymer of methacrylic methyl and styrene (MS), polyvinyl alcohol (PVA), polychlorovinyldiene (PVDC), polyethylene terephthalate (PET), polyamide (PA) known as an engineering plastic, polyacetal (POM), polycarbonate (PC), polyphenylene ether (PPE (altered PPO)), polybutylene terephthalate (PBT), ultra-high-molecular-weight polyethylene (UHMW-PE), polyvinylidene fluoride (PVDF), polysulfone (PSF) known as a super engineering plastic, polyethersulfone (PES), polyphenylenesulfide (PPS), polyarylate (PAR), poly(amide-imide) (PAI), polyetheramide (PEI), polyetheretherkeytone (PEEK), polyimide (PI), liquid crystal polymer (LCP), polytetrafluoroethylene (PTFE) and the like.

Thermosetting resins assume a three dimensional structure or a network structure when heated by itself or with a second substance and become a non-softening non-melting resin. That is, once they are hardened they cannot be softened. These resins activate a chemical reaction at a certain temperature, and begin crosslinking and hardening, and the hardening process is completed by continuing to heat at the hardening temperature. Cooling is performed slowly to attain the hardened state so as to prevent shape changes and generation of residual internal stresses. Thermoplastic resins, when subjected to heating and a certain temperature is exceeded, become soft and flowing without causing a chemical reaction, and when cooled, it becomes hard, that is, it returns to its original property.

FIG. 2 shows a schematic diagram of an injection molding machine. The injection molding machine has a pressurizing head 19 for injecting a molten material held in a cylinder chamber 16a inside the cylinder 16 into a metal mold 15. A screw 17 is rotated by an oil pressure motor 12 to rotate the screw 17 to transfer a resin feed material poured from a feed opening 18 by pushing it into a space 16 in front of the pressure cylinder 19. Around the periphery of the cylinder 16, a heater 13 is disposed, and heats the feed material while it is being transferred by the screw 17 to heat to a temperature above its melting point of the resin to transform the solid resin into a liquid feed material. And, by pushing the pressuring head 19 towards the mold 15 using the injecting oil pressure driver 11, the space section 15a of the metal mold 15 is filled by the liquid feed material.

That is, the feed granules comprised primarily of abrasive particles and the resin is poured in from the feed opening 18, and by rotating the screw 17, it is forwarded from the supply section 18 to the injection section 16a. During this stage, the feed granules are heated by the heater 13, melted and liquefied. By reciprocating the pressurizing head 19, the liquid feed material is injected into the space section 15a of the metal mold 15 and is made into a product form. After which, it is cooled, removed from the mold and becomes a product. Injection molding resins include such general thermoplastic resins as vinyl chloride resin, vinylidene chloride resin, polystyrene methacrylate resin, polycarbonate cellulose acetate, polyacetal polyamide, polypropylene, polyethylene, 3-ethylene fluoride resin, vinylidene fluoride resin and the like, and it is allowable to use in part such thermosetting resins as phenol resin, polyester resin, diarylphalate and the like to enable to use various resins for forming. Also, many products can be produced in one run, and the number of processing steps is reduced compared with compression molding, and the manufacturing time is shortened such that complex parts can be formed at high precision and high productivity can be achieved in mass production. Also, by selecting the mixing proportion of abrasive particles and the grain size of the resin, it is possible to carry out cold compression molding and hot compression molding. In this case also, there is no need for high temperature treatment so that working time is not limited and handling is facilitated.

Especially, when ABS resin is used as a binder, it allows soft polishing due to thermoplastic action of the resin as the temperature of the polishing object is raised, and furthermore, because the structure of ABS resin is such that a core-shell structure is formed by ABS resin surrounding a nucleus of butadiene rubber so that even when the temperature generated by polishing action is lower than the softening temperature of the resin, polishing can be carried out with a lesser degree of scratches (damage) to enable a high quality planarization process. That is, ABS resin has an inherent elasticity in its constitution so that it is as hard as an AS resin from a macroscopic viewpoint so as to produce high planar surface by polishing the object surface, but from a microscopic viewpoint, shock absorbing action is provided by the soft butadiene rubber to lead to suppression of scratches (damage). Here, in addition to ABS resin, similar elasticized structure is found by adding methacrylate butadiene styrene (MBS) as a property modifier to vinyl chloride. By so doing, MBS is made to act as an elasticizer, so that, similarly, from a macroscopic viewpoint, the product is hard to produce superior planar surface during polishing, but from a microscopic viewpoint, it provides a shock absorbing quality due to the elastic component that behaves soft and pliable. When the proportion of MBS resin is increased, i.e., when it forms the main component in the binder, the fixed-abrasive polishing tool exhibits a highly effective impact absorbing effect.

As shown in FIG. 1B, similar effects are obtained when fine rubber particles are mixed with the abrasive particles and binder (plastic material). Specific examples of rubber type particles to be added to plastic materials include natural rubber (NR), styrene butadiene (SBR), butadiene (BR), chloroprene (CR), butyl (IIR), nitrile (NBR), ethylenepropylene (EPM, EPDM), chlorosulfone polystyrene (CSM), acrylic rubber (acrylic esters such as a copolymer ACM of acrylic alkylester and a bridging monomer, and a copolymer ANM of acrylic alkylester and acrylonitril), urethane rubber (U), silicone rubber (SI), fluoro rubber (FKM), high sulfured rubber (T) and the like. Especially, chlorosulfone polystyrene (CSM) is highly resistant to weathering, acid, inorganic chemicals and wear, and acrylic rubber (acrylic esters such as a copolymer ACM of acrylic alkylester and a bridging monomer, and a copolymer ANM of acrylic alkylester and acrylonitril) is highly resistant to heat, and fluoro rubber (FKM) is resistant to heat, chemicals and weathering, and silicone rubber (SI) is not only resistant to heat but is useable over a wide range of temperatures and is suitable for polishing applications because of it is relatively stable in the polishing environment.

Also, in addition to rubber type particles, hollow elastic particles are also effective. For example, hollow particles of polyacrylonitrile (PAN) are applicable.

It is noted that to perform high quality polishing, it is necessary to achieve uniformity of polishing action within the abrading plane of the fixed-abrasive polishing tool, and for this reason, it is necessary to provide a uniform distribution of abrasive particles. Many of the resins are polymers and do not have good wettability with abrasive particles made of metal oxides, and they tend to cluster as large clusters within the microstructure of the polishing tool. For example, when cerium oxide fine particles are mixed with ABS binder, abrasive particles are not wettable by the resin well, and clusters of sizes ranging from several hundred nanometers to several millimeter are found sometimes. The distribution is improved by adding surface-active agent to enable high quality polishing. In addition to surface-active agent, it may be considered that particle distribution can be made more uniform by kneading well, over a long period of time, but this is time consuming and is not efficient. By using a surface-active agent, the surface tension is lowered and uniform distribution of particles can be obtained. For example, by adding 0.01-0.2% non-ionic activating agent to urea group resin, it is known that the surface tension may be lowered from 63 to about 50 dynes/cm.

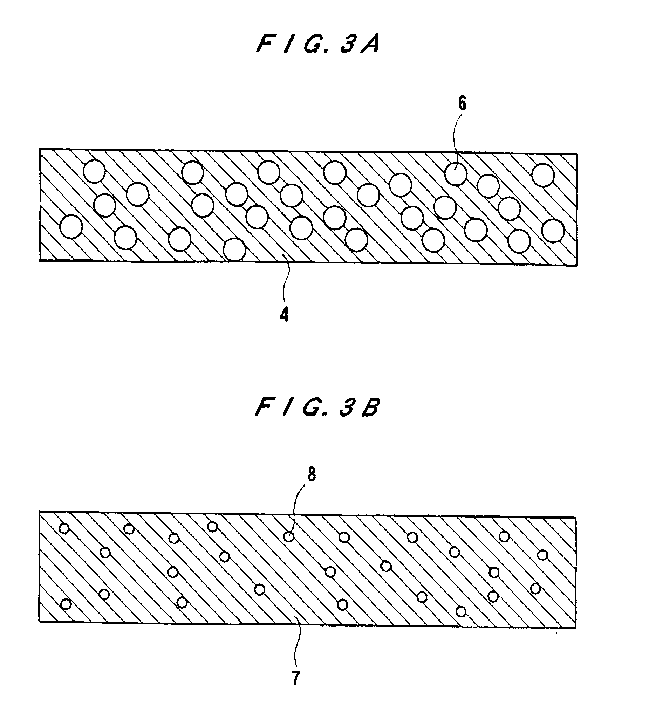

Above explanations relate to the examples of the structure of fixed-abrasive polishing tools, but such examples may be applied to a polishing pad to be used with a slurry containing a large amount of abrasive particles. If the polishing pad contains high hardness resin, flatness of the polishing surface is obtained, but the surface is vulnerable to severe scratches (damage). Therefore, as shown in FIG. 3A, while making the polishing pad using a hard resin 4, soft rubber type particles 6 are mixed within the structure to prevent the formation of scratches.

Specific examples of rubber include, similar to the case of fixed-abrasive polishing tools, natural rubber (NR), styrene butadiene (SBR), butadiene (BR), chloroprene (CR), butyl (IIR), nitrile (NBR), ethylenepropylene (EPM, EPDM), chlorosulfone polystyrene (CSM), acrylic rubber (acrylic esters such as a copolymer ACM of acrylic alkylester and a bridging monomer, and a copolymer ANM of acrylic alkylester and acrylonitril), urethane rubber (U), silicone rubber (SI), fluoro rubber (FKM), high sulfured rubber (T) and the like. Especially, chlorosulfone polystyrene (CSM) is highly resistant to weathering, acid, inorganic chemicals and wear, and acrylic rubber (acrylic esters such as a copolymer ACM of acrylic alkylester and a bridging monomer, and a copolymer ANM of acrylic alkylester and acrylonitril) is highly resistant to heat, and fluoro rubber is resistant to heat, chemicals and weathering, and silicone rubber (SI) is not only resistant to heat but is useable over a wide range of temperatures and is suitable for polishing applications because of it is relatively stable in the polishing environment. Also, in addition to rubber type particles, hollow elastic particles are also effective. For example, hollow particles of polyacrylonitrile (PAN) are applicable. Resin materials used in the fixed-abrasive polishing tools can also be used.

FIG. 3B shows a case of using ABS resin for a polishing pad. When ABS resin 7 is used for the polishing pad, although the ABS resin is hard from a macroscopic viewpoint, it contains small and soft butadiene rubber 8 within its structure. Therefore, the abrading surface is as hard as an acrylonitrile styrene resin (AS:SAN) from a macroscopic viewpoint so as to enable to produce a highly flat surface by polishing, but from a microscopic viewpoint, shock absorbing effect is provided by the soft butadiene rubber particles so as to suppress the formation of scratches, thus enabling to provide high quality polishing action.

Next, a typical production process of ABS resin based tool will be explained. ABS resin has a core-shell structure in which polybutadiene rubber particles are distributed in a AS resin matrix. A typical method of production is based on emulsion polymerization that provides relatively easy control over the interface between the resin phase and the rubber particles or the rubber phase. Typical production process for ABS resin involves steps such as, a rubber latex manufacturing process by making emulsion copolymerization of butadiene to produce polybutadiene latex; carrying out a graft polymerizing process by adding acrylonitrile and styrene to the latex solution (or adding abrasive particles) to carry out graft reaction due to emulsion polymerization; solidifying the polymer; and dehydrate and drying. Butadiene latex can be obtained by emulsification by charging butadiene, water, emulsifying agent, catalyst and polymerization adjuster in a tank polymerizer with stirring, but fundamentally, it is the same as emulsion polymerization, and the polymerized substance thus obtained are controlled by controlling the polymerization formula and polymerization operation to control the rubber particle size and the occluded amount of gel (bridging structure) and the like. In addition to the process of emulsion polymerization described above, graft blend process is also known in which an AS copolymer latex body consisting only of acrylonitrile and styrene is made in a separate process, and it is mixed with a graft copolymer latex, solidified and dehydrated and dried.

Next, fixed-abrasive polishing tools made using butadiene styrene, polybutadiene or acrylic rubber group MBS resin will be explained. The MBS resin in a wider context is a graft polymer having a core-shell structure of a core of butadiene styrene, polybutadiene or acrylic rubber, and is used primarily as a property modifier for shock absorbing quality of vinyl chloride resin or acrylic resin. MBS resin is a thermoplastic copolymer made of methylmethacrylate and butadiene and styrene as raw materials, and has the core-shell structure consisting of a core of copolymer (SBR) containing a rubber layer of butadiene and styrene, and the shell of copolymer (MS) of methylmethacrylate and styrene.

Regarding the fixed-abrasive polishing tool based on a binder made by adding an MBS resin to vinyl chloride or acrylic resin, and generally, the addition is about several to 20 %, and is designed to emphasize the characteristics of vinyl chloride. In contrast, if the amount of MBS resin in the binder resin is increased to over 20 %, 50 % or even 100 %, the tool has a very high shock absorbing property. By using this resin as the binder and combining with cerium oxide abrasive particles, fixed-abrasive polishing tools that create very little scratches will be produced. For example, epoxy resin and MBS resin may be used together as a binder. That is, the fixed-abrasive polishing tool thus made is easy to manufacture, because the MBS resin is thermoplastic, and produce high strength body. When MBS resin is used as the binder, self-stopping effect is generated, thereby providing fast polishing rates. For example, compared with the fixed-abrasive polishing tool based on the binder of conventional epoxy resin, about two times faster polishing rate can be achieved. Further, because the resin body itself is shock absorbing, the force acting on the abrasive particles is moderated (suppressed) to enable to provide scratch-free polishing, i.e. less defects in the polished product. It is considered that MBS resin promotes self-generation of abrasive particles because of the retaining power for the particles is reduced due to spreading of matrix itself caused by the effects of absorption of water.

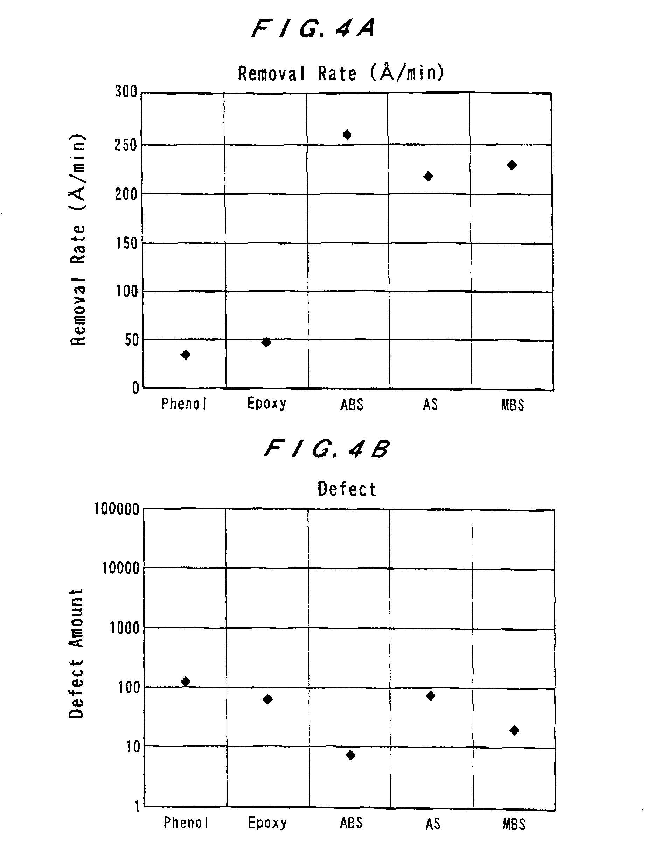

FIG. 4 shows experimental data of comparison of polishing results produced by various fixed-abrasive polishing tools made with various resins in terms of (a) polishing speed and (b) number of defects. It can be seen that, as shown in FIG. 4A, in fixed-abrasive polishing tools made with ABS resin, AS resin, and MBS resin, the polishing speeds are much faster relative to the fixed-abrasives polishing tools made with phenol resin and epoxy resin. Also, as shown in FIG. 4B, data show that in the tools made with ABS resin, AS resin and MBS resin number of defects per unit area are equal to or less than those made with phenol or epoxy resin. That is, fixed-abrasives made with thermoplastic resins generally exhibit higher polishing speed and the number of defects is lesser. Particulary fixed-abrasives made with ABS resin or MBS resin exhibit higher polishing speed and less number of defects such as scratches and adhering matters observed after polishing.

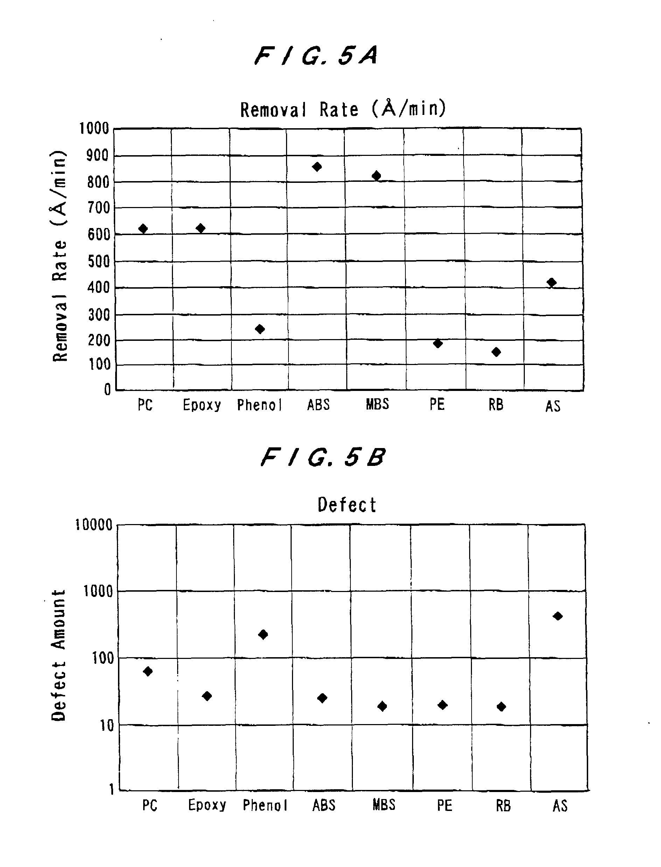

FIG. 5 shows the experimental results of comparing with polishing pad that does not contain abrasive particles in terms of (a) polishing speed and (b) number of defects. These experimental results relate to various resins including PC (polycarbonate), epoxy, phenol, ABS (acrylonitryl butadiene styrene), MBS (methylmethacrylate butadiene styrene), PE (high density polyethylene), RB (butadiene rubber), AS (acrylonitryl styrene). These experimental results also demonstrate that the polishing pads made with ABS resin or MBS resin exhibit higher polishing speed and less number of defects.

Some examples of the structure of the fixed-abrasives by MBS resin will be explained.

Ratio of the fixed-abrasive (percentages of abrasive particles(Vg), binder(Vb) and air porosity(Vp)) in volume percent (vol%) is, for example:
abrasive particles (Vg): binder (Vb): air porosity (Vp)
= 35: 55: 10 (vol%).

This fixed-abrasive polishing tool exhibits faster polishing speed and produce less defects, compared with the common phenol epoxy resin bonded polishing tools, so that it is applicable to semiconductor manufacturing processes that prefer not to create scratches. For those processes requiring highspeed polishing that require in-situ dressing, by the use of the common phenol or epoxy resin bonded polishing tools, the present polishing tool can be used for such highspeed polishing processes without requiring such in-situ dressing. Also, because there is no danger of diamond particles falling from the tool, scratches caused by diamond particles are not created.

Next, compositions of the fixed-abrasive polishing tool based on MBS resin will be explained.
Composition of fixed-abrasives (percentages of abrasive particles (Vg), binder (Vb) and air porosity (Vp)) in volume percent (vol%), are as follows.

In general, the range is: 10 %< abrasive particles (Vg)<50 %, 30 %< binder (Vb) <80 %, and
0 %< air porosity (Vp) <40 %.

It is preferable that the range be:
20 %< abrasive particles (Vg)<45 %,
40 %< binder (Vb) <70 %, and
0 %< air porosity (Vp)<20 %.

It is more preferable that the range be:
30 %< abrasive particles (Vg) <40 %,
50 %< binder (Vb)<60 % and
5 %< air porosity (Vp)<15 %.

Next, a method of making the fixed-abrasive polishing tool will be explained. First, a dry powder of a mixture of fine cerium oxide, and butadiene styrene, polybutadiene or acrylic rubber group MBS resin is prepared. A specific example of the method of obtaining the dry feed powder will be explained next.

The first method is to mix a powder of abrasive particles, and butadiene, polybutadiene or acrylic rubber group MBS resin powder, and such a mixed powder is easily prepared.

The second method is to prepare a slurry type polishing solution made by adding, as necessary, water and/or aqueous solution and/or solvent and/or binder and/or chemical to the abrasive particles, and drying the slurry by drying naturally or by heating or by freeze drying, after which, pulverizing the powder as required, and mix the powder with butadiene styrene, polybutadiene or acrylic rubber group MBS resin powder to obtain the dry feed powder. However, because the abrasive particles are extremely fine, they tend to agglomerate so that, in order to prepare a powder of the abrasive particles only, spray drying or other drying method is used to obtain a powder of average particle size 1-500 µm that shows weak aggregating force or binding force and exhibits easy handling quality, or preferably 10-100 µm, or more preferably 30-80 µm range. The binder that shows strong binding force is not suitable for inclusion in the polishing slurry so that it is preferable to select a binder that binds due to bridging or intermolecular forces, or weak binding force (includes resin binders of weak binding force).

The third method for obtaining a dry feed powder is to produce a powder according to the first or second method, and then, the powder is dispersed in water or an aqueous solution or a solvent, and then dry the liquid by drying naturally or by heating or freeze drying or spray drying. This dry feed powder is desirable because it facilitates mixing of abrasive particles and the resin powder so that uniform composition is more easily obtained in the finished fixed-abrasive polishing tool. In this case also, by using a spray dryer or other mist dryer and selecting the operating conditions, average particle size and particle distribution can be controlled to obtain a feed powder that is easy to handle and suitable for forming operation. For example, the average particle size should be in a range of 1-500 µm or preferably 10-100 µm or more preferably 30-80 µm.

The fourth method is to prepare a slurry type polishing solution made by adding, as necessary, water and/or an aqueous solution and/or a solvent and/or a binder and/or a chemical to the abrasive particles, and adding butadiene styrene, polybutadiene or acrylic rubber group MBS resin powder to the liquid mixture and adding, as necessary water or an aqueous solution or a solvent, to mix or to mix and disperse, and drying the liquid mixture by drying naturally or by heating or by freeze drying or mist drying including spray drying to obtain the dry feed powder. In this case also, average particle size and particle distribution can be controlled by using spray drying or other mist drying methods so as to obtain a powder of easy handling and forming qualities. For example, the average particle size should be in a range of 1-500 µm or preferably 10-100 µm or more preferably 30-80 µm. The most preferable method of mixing the feed materials is to mix abrasive particles in a slurry with an MBS resin in a liquid state (latex), and mist drying the liquid using spray drying to make the feed particles. This method enables uniform mixing of slurry and MBS resin. It should be noted that uniform mixing in MBS resin is possible even if the particles are not supplied in a slurry form, but are supplied as primary particles obtained beforehand by spray drying a slurry at a low temperature (room temperature to 200 °C).

The fifth method is used when the butadiene styrene, polybutadiene or acrylic rubber group MBS resin powder are in a form of an aqueous solution or an emulsion, the liquid material is dried first and the dried powder is mixed with abrasive particles to obtain the feed powder. Also, after dispersing in water or an aqueous solution or a solvent, a binder and/or a chemical is added, as necessary, and obtain the feed powder by drying and pulverizing. This method also facilitates mixing of abrasive particles, resin powder and additives uniformly. In this case, a desirable feed powder is obtained that promotes the formation of uniform composition in the fixed-abrasive thus formed.

The sixth method is used when the butadiene styrene, polybutadiene or acrylic rubber group MBS resin powder is in a form of an aqueous solution or an emulsion, abrasive particles or raw particle material in a slurry form is mixed or mixed and dispersed in water or an aqueous solution or a solvent, as necessary, and after drying, the dried powder is again dispersed in aqueous solution or solvent, and a binder and/or chemical is added as necessary, by drying or dry commination processing to obtain the feed material. In this case also, the feature is that abrasive particles, the resin and the additives are uniformly mixed, and that a desirable feed powder is obtained that promotes the formation of uniform composition in the fixed-abrasive polishing tool.

Further, drying and mixing and charging the metal mold with the feed material can be carried out concurrently in the metal mold to be used in the method shown next, so that the manufacturing process is desirably shortened.

Next, the forming process for the fixed-abrasive polishing tool involving charging the feed material and heating and press forming will be explained. Because MBS resin is a thermoplastic resin that is softened by heating, the polishing tool can be produced simply by charging the feed material in the metal mold and heating the mold. In so doing, the metal mold does not need to be heated, but to control the shape or the amount of porosity in the formed fixed-abrasive polishing tool, it is preferable to carry out this process while applying a pressure. In making the fixed-abrasive polishing tool, in order to obtain a certain size and amount of porosity in the fixed-abrasive polishing tool, it is preferable to use a mold having a stopper device so as not to compress indefinitely to a small volume. The stopper device avoids a pressure-dependent forming and enables a volume-dependent forming so as to enable to impart a certain shape and amount of porosity to the fixed-abrasive polishing tool. After the process of heating/compaction, the surface and the outer radius are fabricated and adjusted, and after a desirable shape has been achieved, it is ready for use in polishing. Also, because the fixed-abrasive polishing tool is a flat shaped tool, and also, the structural form and the material are vulnerable to distortion and volume expansion due to moisture absorption, the fixed-abrasive polishing tool must be sufficiently wetted during any fabrication process so that the water content within the tool does not become unbalanced.

Next, a specific example of manufacturing process for a fixed-abrasive polishing tool containing cerium oxide particles and MBS resin binder will be explained. The finished size of the fixed-abrasive polishing tool is a diameter of 55 cm and a thickness of 5 mm or more, as an example. The volume ratio of the abrasive particles and the binder material before the forming operation is 29-49 % (preferably 34-44 %) of abrasive particles and the remainder 51-71 % (preferably 56-66 %) of binder material. The fixed-abrasive components may include, in addition to abrasive particles and binder, additives such as surface-active agent, polishing promoter and elastic material such as rubber may be added or more than two kinds of resins may be mixed for use in the feed material. Then, the volumetric composition of the finished fixed-abrasive polishing tool is comprised by 25-45 % (preferably 30-40 %) abrasive particles, 45-65 % (preferably 50-60 %) binder and 0-20 % (preferably 5-15 %) porosity, so that a target value may be: abrasive particles: binder: porosity = 35: 55: 10, for example. MBS resin is a thermoplastic resin, and it is preferable that the forming temperature be in a range of 150-200 °C.

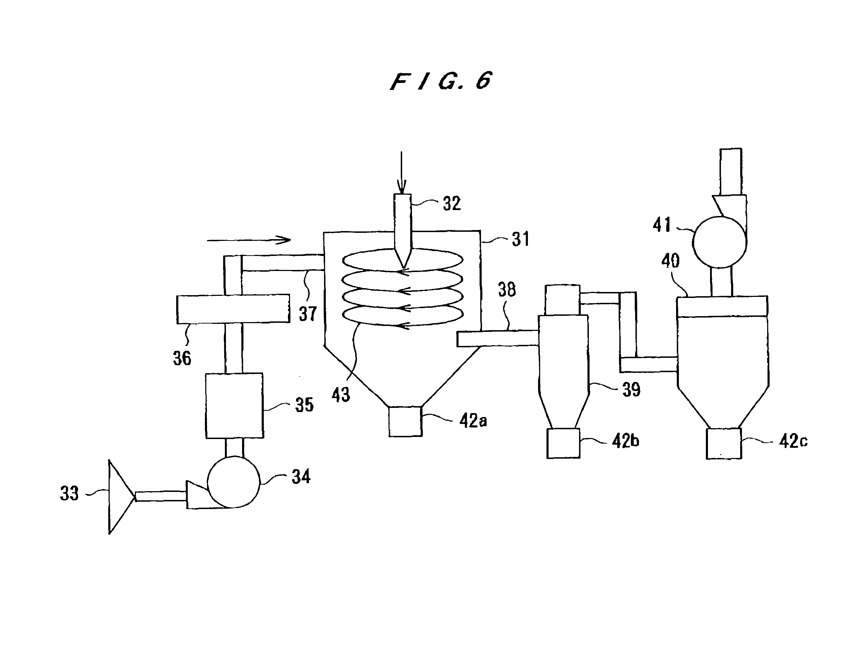

Drying treatment can be either natural drying or by heating, but as shown in FIG. 6, it is preferable to use spray dryer. The feed material is heated and dried by spray drying, and thermoplastic MBS resin is melted and is then dried to form clusters having a spherical shape or cavities. Therefore, the feed material before and after spray drying is mixed uniformly and its handling quality is improved. It is preferable to mix all the feed material before charging the feed material into the metal mold.

If the mold is charged with a feed material in the liquid form, when heating and compaction steps are performed, the water evaporates so that the fixed-abrasive polishing tool is formed with water inclusions or hollow portions so that a desirable fixed-abrasive polishing tool of uniform structure is not produced. Therefore, it is preferable to charge the forming device with dried feed powder.

Drying and pulverization process using spray drying is carried out as follows.

Spray drying method is carried out by first dispersing the particles or raw materials such as MBS resin in water or solvent, and after dispersing the mixture sufficiently by applying ultrasonic stirring and the like so as to form an emulsion of fine particles. Then, the emulsion of fine particles is charged into a spiraling space of hot air. In so doing, the liquid portion of the emulsion is instantly vaporized, and the fine particles are formed into agglomerated bodies while increasing the surface area per unit volume. If, for example, fine particles of 0.3 µm diameter are used in forming abrasive particles, spherical grains of 5-100 µm comprised by agglomerated bodies of fine abrasive particles are produced. According to this spray drying method, a number of processing steps such as condensing, filtering, pulverizing, classifying and drying are carried out concurrently, and therefore, particulate forming process that starts with fine particles and ends in forming aggregates can be carried out easily. The particle size of the grains (post- polymerization size) is different for different forming methods, and for hot pressing, the range is 1-1000 µm, preferably 5-500 µm or more preferably 100-200 µm.

Here, the particle size can be adjusted when drying and particulate forming (granulating) are carried out using spray drying, by adjusting the operating parameters of the spray dryer such as the temperature of hot air, atomizer shape, atomizer rotation speed, hot air discharge rate, air temperature, and the parameters of the liquid to be supplied to the spray dryer such as viscosity, solid volume and the liquid feed supply rate.

FIG. 6 shows an example of the spray dryer suitable for use in the above method. The dryer main body 31 of the spray dryer receives hot air through a pipe 37, and a spiraling flow 43 is formed in the dryer main body 31. Air is sent by a blower 34 and is heated by a heater 35, which supplies hot air into the dryer main body 31 through the air filter 33. Micro-particle forming apparatus 32 supplies an emulsion of fine particles into the swirling hot air, thereby forming aggregated abrasive particles. Aggregated bodies made into grains are either discharged in the vessel 42a situated below the dryer main body or classified by entering a cyclone 39 through the pipe 38, and enter either a chamber 42b situated below or classified by a bag filter 40 and enter a chamber 42c situated below. Hot air passed through the bag filter 40 is discharged by the discharge fan 41.

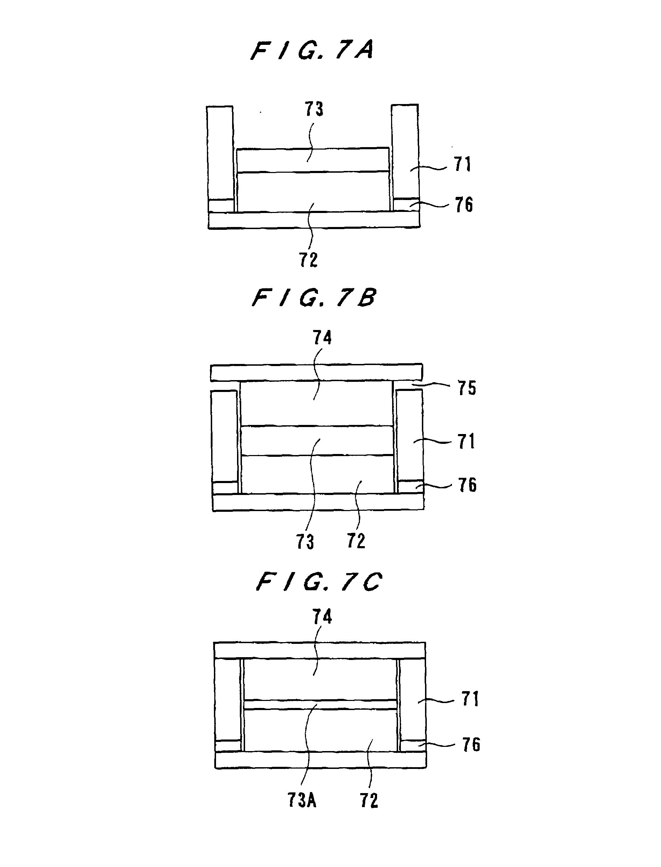

Next, a forming process of a fixed-abrasive polishing tool will be explained with reference to FIG. 7A, 7B and 7C. First, as shown in FIG. 7A, after assembling the die 71 and the lower punch 72, the feed powder 73 of mixed powder of abrasive particles and resin particles is uniformly packed into the mold. Next, as shown in FIG. 7B, the upper punch 74 is placed on top without loading the charge or setting a forming fixture with a minimal pressure less than the forming pressure of the compact, and the compact is heated to a certain forming temperature (for example, 150-300 °C) that exceeds the glass transition temperature of the resin but lower than the temperature that causes thermal decomposition. Then, this condition is maintained for a period of time sufficient to homogenize the temperature and to melt the resin uniformly (for example, 5-30 min). Next, pressure is applied to the upper punch 74 until a target volume is reached. In doing so, as shown in FIG. 7B, use of a forming fixture having a stopper device 75 enables to compress to a specified volume.

The fixed-abrasive while it is being hardened is pressed from upper portion so that the pressure spreads laterally and the die contacts the fixed-abrasive feed material intimately. For this reason, by removing the spacer disposed below the die midway in the hardening process, the die is able to move as a unit with the fixed-abrasive feed material so as to prevent distortion of the peripheries of the fixed-abrasive body, and also, the density of the fixed-abrasive body is made uniform. Also, the spacer may be inserted initially under the die 71, and after pressing with sufficiently small pressure than the forming pressure, and after removing the spacer, the forming pressure may be applied. Although the tool may be formed without using the spacer, it is desirable to use the spacer for the purpose of relieving the internal stresses in the formed product and to equalize the density. Further, press-forming may be carried out by controlling the position of the upper punch 74. After holding for a given period of time, the compact is preferably cooled naturally, and after cooling down to a temperature sufficiently lower than the glass transition temperature, the fixture is removed from the mold to obtain a fixed-abrasive polishing tool 73. Here, the fixed-abrasive polishing tool can be manufactured by controlling the time and pressure without using a forming fixture having the stopper mechanism illustrated in the diagram.

After the forming process of the fixed-abrasive polishing tool, it is subjected to shaping of the external surfaces to produce a product. Because the fixed-abrasive polishing tool lacks sufficient strength so that, if it is unsupported, transporting and attaching to a machine may cause to break or damaged, and therefore, it is fixed to a holder base. Mounting on the holder base (by bonding, adhesion or mechanical fixation) can be performed during the forming process for the tool, but if thermal coefficients are different or the material is liable to degrade, it is preferable to do so after the forming process. It is better that the fixed-abrasive polishing tool has some thickness from the viewpoint of wear, but if wear is expected to be low during its use, a thin flat shape may be adopted. When using the fixed-abrasive polishing tool for polishing, water or a liquid is often applied during the polishing process. Therefore, there is a problem of swelling of the fixed-abrasive polishing tool so that when the tool is to be mounted on a holding base, it is preferable that the tool be mounted in a slightly swelled condition to approximate the condition of use. That is, a liquid should be infiltrated into the interior of the fixed-abrasive polishing tool so as to simulate the swelled condition in such a way that the size and shape of the tool are stable, and then to mount the tool on a holding base, and it is preferable to maintain this condition until the tool is put to use.

Typical manufacturing process for the fixed-abrasive polishing tool is as follows. A dispersion liquid containing a MBS resin and a slurry containing cerium oxide particles of 0.165 µm average particle size is prepared. The liquid is dried in the spray dryer to form particulates having a particle distribution in a range of 9-200 µm and an average particle size of 45 µm. The feed powder is charged into a metal mold of about 560 mm diameter, and hot forming is carried out by hot pressing at a temperature of about 200 °C. Further, after mounting on a holder base (cartridge plate for attaching to the turntable of a CMP apparatus) using a bonding agent, outer diameter fabrication and polishing surface planarization are carried out to produce a fixed-abrasive polishing tool.

Next, the glass-transition temperature of thermoplastic resin will be examined. First, it is necessary that the polishing tool has sufficient strength during polishing operation. For this reason, the glass-transition temperature Tg is higher than room temperature (20-25 °C). And, when the polishing tool is not in contact with the polishing object, it is necessary that the polishing tool retain brittleness so that polishing action pulverizes the resin into fine polishing debris so as not to interfere with the polishing process. For this reason, it is also necessary that the glass-transition temperature Tg be above room temperature. Also, if the resin softens even at room temperature, when the polishing tool is in contact with a polishing object (semiconductor wafer, for example), the polishing surface becomes too soft, and flatness of the polished surface cannot be produced. Also, there is a problem that the resin tends to agglomerate with the abrasive particles if the resin has flows too readily. Therefore, it is preferable that only the topmost layer of the polishing tool that in contact with the polishing object be in a softened state. Normally, when polishing the surface of a semiconductor wafer, the temperature of the surface reaches a temperature of about 60 °C. From such a viewpoint, it is preferable that the glass-transition temperature of a resin to comprise the polishing tool be higher than 60 °C. From the viewpoint of formability during manufacturing of the present polishing tool, if the glass-transition temperature Tg is too low, it becomes difficult to detach from the mold. From this viewpoint, it is preferable that the glass-transition temperature be higher than 50 °C. Further, productivity and cost reduction can be achieved if it is possible to form at a relatively low temperature. From the viewpoint of manufacturing the polishing tool, it is preferable that the glass transition temperature be lower than 200 °C. From the overall viewpoint based on above discussion, the glass-transition temperature Tg of the resin to comprise the present polishing tool should be higher than room temperature and lower than 200 °C.

However, because resin materials are generally hydrophobic, it is difficult to retain the slurry on the pad surface. Therefore, to perform stable polishing operation, it is necessary to perform an operation called dressing (seasoning). That is, the surface is lightly abraded using a diamond file, and after removing the debris and roughing the surface, the surface area is increased so as to promote retention of slurry on the surface. If the pad itself is hydrophilic, the extra step of dressing to increase the surface area is not needed and only the debris must be removed, so that the dressing cost of the pad is reduced and the pad can be used over a longer period. Materials that exhibit hydrophilic nature include all those materials containing hydrophilic base such as -CH-OH, -OH, -NH₂, -NHCONH₂, -(OCH₂CH₂)N- among others. Also, a base containing an element such as oxygen, nitrogen, sulfur is hydrophilic, and especially if a salt is formed, it is strongly hydrophilic and is very suitable for this purpose. Strongly hydrophilic nature is exhibited by such bases as -SO₃H, -SO₃M, -OSO₃H, -OSO₃M, -COOM, -NR₃X (where M: an alkaline metal or -NH₄R: alkyl base, X: halogen). By adding such hydrophilic substances to the resin forming the polishing pad or to impart hydrophilic property to the resin itself, that is, to modify its nature, a polishing pad may be obtained that holds slurry on the surface during polishing.

The technology for mixing abrasive particles and a resin in a liquid to achieve uniform mixing is applicable to thermosetting resins also. As an embodiment, a case of mixing phenol resin liquid and ceria slurry and a case of mixing phenol resin liquid and silica slurry will be described.

If the thermosetting resin is a solid powder, it may be liquefied by dissolving or forming micro-dispersion in an organic solvent such as ethanol, methanol and the like. The solvent may also be water.

If the viscosity of a resin in the liquid form is high, it may similarly be dissolved or dispersed in pure water or an organic solvent such as ethanol. This step is important for obtaining uniform dispersion in the later operation for mixing the abrasive particles. In this case, dispersion method used was mechanical stirring, but other methods such as ultrasonic dispersion method may be utilized, or a combination of several methods may be adopted. In general, joint use of both stirring and ultrasonic dispersion produces superior results.

Mixing of slurry and liquid resin is performed after adjusting the viscosity of each material to be the substantially the same. If the viscosity of one material is higher than that of the other material, the viscosity should be adjusted before mixing, by diluting with water or other solvent so as to adjust their viscosity values are substantially the same, to achieve more uniform mixing of the abrasive particles and the resin. The liquid resin is a solution such as emulsion, latex, or suspension in which resin is dispersed or dissolved in a liquid such as water or other solvent.

The thermosetting resin in a liquid form and an abrasive particle slurry are uniformly mixed and dispersed. In this case also, joint use of ultrasonic dispersion may be applied as mentioned above. Also, dispersion treatment does not have to be applied separately to the thermosetting resin liquid and the abrasive particle slurry, so that the dispersion treatment may be applied for the first time when the two materials are mixed.

The mixed solution produced in the above operation is dried in the spray dryer or by using other mist drying methods, and after the drying and granulating operations, a mixed powder material is produced.

The mixture obtained in the above step is charged uniformly in a metal mold and is thermo-pressed to produce a green compact. In performing such an operation, because the present mixture is a powder produced by uniformly mixing thermosetting resin and abrasive particles, there is no change in the mixing ratio of thermosetting resin, and charging of the powder into the metal mold is facilitated. The metal mold is comprised by upper and lower dies and spacers shown in Figure 7. Because the thermosetting resin hardens by heat, forming can be carried out at constant pressure. In this case, after pressing at a lower pressure, the spacers are removed, so that the dies are floated, and they are pressurized again. After maintaining this state for a time, it is cooled, demolded to obtain a fixed-abrasive plate.

After the molding operation, it is fabricated to form planar surfaces and outer radius to produce a desired shape for use in polishing. Also, because the fixed-abrasive polishing tool is made into a planar shape and the structural body and the material are susceptible to deformation and expansion due to moisture, it is important to avoid creating non-uniform moisture distribution in the tool by providing sufficient water during such fabrication operations of the fixed-abrasive polishing tool.

It should be noted that liquid mixing of the abrasive particles and the resin may be carried out by mixing the powder abrasives and phenol resin liquid in the liquid, followed by mist spray drying to produce a mixed powder feed for granulating.

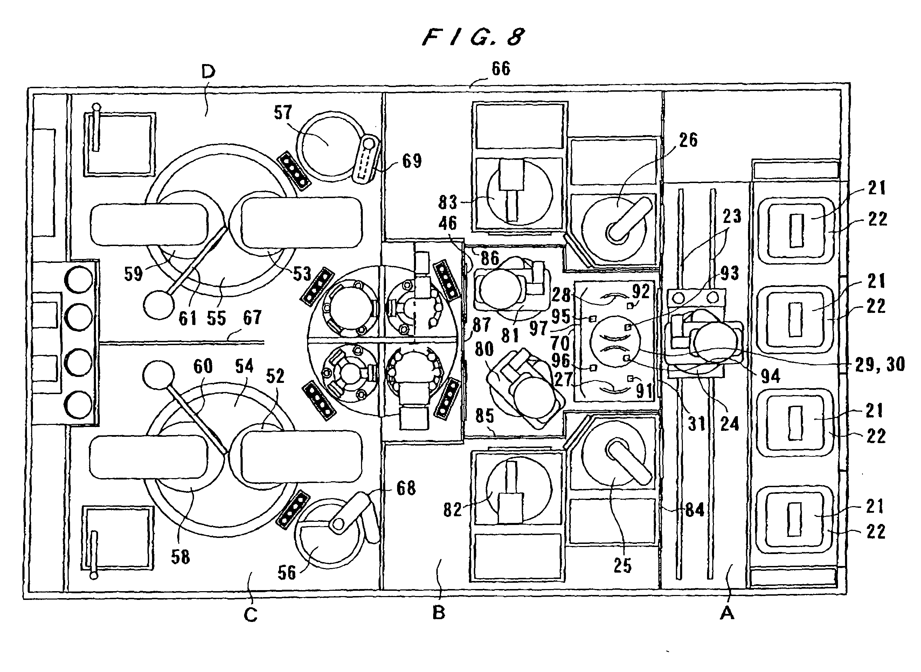

FIG. 8 shows a plan view of a polishing facility related to the present invention for primarily polishing semiconductor wafers. This polishing facility uses the fixed-abrasive polishing tool or the polishing pad described above.

The polishing facility shown in FIG. 8 is provided with four load/unload stages 22, each having a wafer cassette 21 for storing many wafers. Load/unload stage 22 may have an elevator device. A transport robot 24 having two hands is disposed on a transport mechanism 23 so that each wafer cassette 21 on the load/unload stage 22 can be accessed.

Of the two hands provided for the transport robot 24, the lower hand is used only when receiving a wafer from the wafer cassette 21, and the upper hand is used only when returning the wafer to the wafer cassette 21. This arrangement is chosen so that the cleaned wafer is placed on top to avoid contaminating the cleaned wafer. The lower hand is a vacuum suction hand for vacuum retention of the wafer, and the upper hand is a drop type hand for supporting the wafer at its periphery. The suction type hand can carry a wafer correctly regardless of shifting of the wafer inside the cassette, and the drop type hand can transport the wafer keeping the back-side of the wafer clean because it does not collect dust as does the suction type hand. Two cleaning machines 25, 26 are disposed opposite to the wafer cassette 21 about the transport mechanism 23 of the robot 24 as the symmetry axis. Each cleaning machine 25 or 26 is disposed so that the hand of the robot 24 can access the machines. Between the two cleaning machines 25, 26, in a location that can be reached by the robot 24, a wafer station 70 is provided to have four wafer platforms 27, 28, 29, 30. The cleaning machines 25, 26 have a spin drying capability for spinning at high-speed to dry the wafers, so that two- or three-stage cleaning operation can be performed without changing control modules.

An isolation wall 84 is provided to isolate the degree of cleanliness in the region B where the cleaning machines 25, 26 and the wafer platforms 27, 28, 29, 30 are disposed from the degree of cleanliness in the region A where the wafer cassette 21 and the transport robot 24 are disposed, and a shutter 31 is provided in the opening section of the isolation wall for transporting the wafers across the two regions. A transport robot 80 having two hands is disposed in a location that enables the robot 80 to reach the cleaning machine 25 and the three wafer platforms 27, 29, 30, and a transport robot 81 having two hands is disposed in a location that enables the robot 81 to reach the cleaning machine 26 and the three wafer platforms 28, 29, 30.

The wafer platform 27 is used to transfer wafers between the transport robot 24 and the transport robot 80, and is provided with a wafer-detecting sensor 91. The wafer platform 28 is used to transfer a wafer between transport robot 24 and transport robot 81 and is provided with a wafer-detecting sensor 92. The wafer platform 29 is used to transfer a wafer from transport robot 81 to transport robot 80 and is provided with a wafer-detecting sensor 93 and a rinse nozzle 95 used for wafer drying prevention or wafer cleaning. The wafer platform 30 is used to transport wafers from transport robot 80 to transport robot 81 and is provided with a wafer-detecting sensor 94 and a rinse nozzle 96 used for wafer drying prevention or wafer cleaning. The wafer platforms 29, 30 are both disposed inside a common water-proof cover, and a shutter 97 is provided on the opening section of the cover for wafer transport. The wafer platform 29 is disposed above the wafer platform 30, and by placing washed wafer on the platform 29 and placing unwashed wafer on the platform 30, contamination caused by falling rinse water is prevented. Further, in FIG. 8, the sensors 91, 92, 93, 94, rinse nozzles 95, 96 and shutter 97 are shown schematically, and their location and shape are not shown accurately.

The upper hands of the transport robots 80, 81 are used to transport a wafer that has been washed once to the cleaning machine or to the wafer platform on the wafer station, and the lower hands are used to transport a wafer that has not been washed at all and an unpolished wafer. By using the lower hands to load or unload a wafer on the wafer inverter, there is no danger of contaminating the upper hands by the water dripping from the wall of the upper section of the wafer inverter.

The cleaning machine 82 is disposed in a location adjacent to the cleaning machine 25 so as to enable the hands of the transport robot 80 to reach it. The cleaning machine 83 is disposed in a location adjacent to the cleaning machine 26 so as to enable the hands of the transport robot 81 to reach it.

The cleaning machines 25, 26, 82, 83, and wafer platforms 27, 28, 29, 30 of the wafer station 70 and the transfer robot 80, 81 are all disposed within region B, and its pressure is adjusted so that it is lower than the pressure in region A. The cleaning machines 82, 83 are able to clean front and back surfaces of a wafer.

The present polishing facility has a housing 66 so as to surround the various machines, and the interior of the housing 66 is divided into a plurality of rooms (includes regions A, B) by means of isolation walls 84, 85, 86, 87 and 67.

A polishing chamber is separated from the region B by the isolation wall 87, and the polishing chamber is further divided into two regions C, D by the isolation wall 67. Inside each of the two regions C, D, two polishing tables and one topring for holding one wafer and polishing the wafer while pressing it against the turntable. That is, polishing tables 54, 56 are disposed inside the region C and polishing tables 55, 57 are disposed inside the region D, and topring 52 is disposed inside the region C and topring 53 is disposed inside the region D. A solution nozzle 60 is provided for supplying a polishing solution to the polishing table 54 located inside the region C, also provided is a dresser 58 for dressing the polishing table 54. A solution nozzle 61 is provided for supplying a polishing solution to the polishing table 55 located inside the region D, also provided is a dresser 59 for dressing the polishing table 55. Also provided are a dresser 68 for dressing the polishing table 56 in region C, and a dresser 69 for dressing the polishing table 57 in region D. A wet type wafer film-thickness measuring device may be provided instead of the polishing tables 56, 57. In so doing, the thickness of film on a wafer may be measured immediately after polishing, so that controls can be exercised over additional material removal for the wafer and setting polishing parameters for the next wafer.

A wafer transported to the topring 52 or 53 is vacuum chucked to the topring, and the wafer is transported in the vacuum chucked state to the polishing table 54 or 55. Then, the wafer is polished by the polishing pad of the present invention or by a polishing surface comprised by the fixed-abrasive polishing tool installed on the polishing table 54 or 55. Use of the polishing pad or the fixed-abrasive polishing tool of the present invention enables to produce superior polished surface having less scratches even in one-stage polishing. In FIG. 6, the second polishing tables 56, 57 described earlier are disposed in locations that can be accessed by the toprings 56, 57. Accordingly, after polishing a wafer in the first polishing table 54 or 55, it may be finished using a finishing pad bonded to the second table 56 or 57. On the finish table 56, 57, finishing is carried out by the pure water method based on supplying pure water to a polishing pad made by SOBA400 or Polytex (both by Rodel Nitta Co.) or finish polishing is carried out by supplying a slurry.

Depending on the type of films deposited on the wafer, after polishing on the second polishing tables 56, 57, the wafer may sometimes be processed further on the first polishing tables 54, 55. In this case, because the polishing surface of the second polishing table is smaller, it is advantageous to carry out rough polishing using the second polishing table bonded with a comparatively expensive fixed-abrasive polishing tool relative to the polishing pad, and then, to carry out finish polishing using the first polishing table bonded with a polishing pad which has a comparatively short life relative to the fixed-abrasive polishing tool. Such a procedure would reduce the operating cost of running the polishing facility. Accordingly, by assigning a polishing pad to the first polishing table and assigning a fixed-abrasive polishing tool to the second polishing table, a low cost polishing system can be produced. In other words, fixed-abrasive polishing tools are generally more expensive than polishing pads, and the larger the diameter the more expensive the tools are. Also, because the service life of the polishing pad is less than that of the fixed-abrasive polishing tool, the service life can be extended when the polishing pad is used under light load. Also, when the size is large, contacts are spread over a wide area so that the service life is extended. Therefore, maintenance cycle can be extended and the productivity is improved.

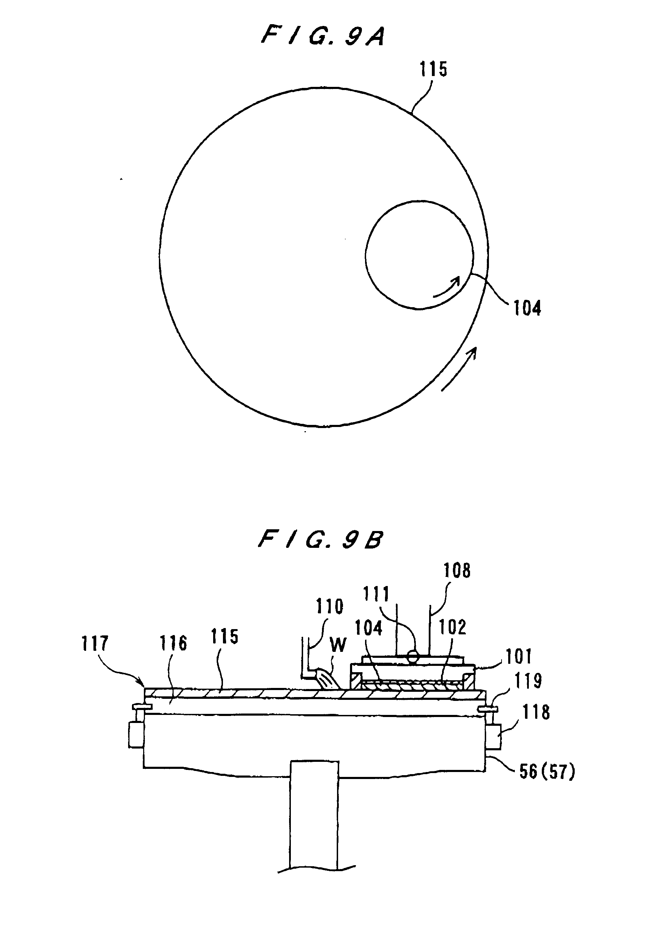

FIG. 9 shows a diagram of essential parts of the polishing apparatus. This polishing apparatus comprises a polishing table 56 (57) having, instead of a polishing pad, a fixed-abrasive polishing unit 117 consisting of a disk 116 bonded with a fixed-abrasive polishing tool 115 of a diameter of about 60 cm; and a spray nozzle 110 for supplying, during polishing, water not containing any abrasive particles or a chemical W. Here, the fixed-abrasive polishing unit 117 is made by bonding the fixed-abrasive polishing tool 115 comprised primarily of a thermoplastic resin such as ABS resin or MBS resin to a metal or ceramic disk 116 using an adhesive. Then, the fixed-abrasive polishing unit 117 is simply but firmly attached to the polishing table 56 (57) by means of clamping devices 118, 119. Wafer polishing parameters are, for example, planar wafer pressure at 300 g/cm²; rotational speed of table/wafer = 30/35 min⁻¹; liquid delivery rate at 200 cc/min; water as liquid (contains less than 1 weight % of surface-active agent). The parameters may be modified to: planar wafer pressure at 500 g/cm²; rotational speed of table/wafer = 25/10 min⁻¹; liquid delivery rate at 200 cc/min; water as liquid (contains less than 1 weight % of surface-active agent).

The structures of the topring 101 that hold other polishing objects 104 is the same as the structures of other tables 54, 55. Reasons for supplying a liquid such as water during polishing to the polishing surface of the fixed-abrasive polishing tool 115 are to provide lubrication of the polishing surface and to remove heat that can be generated by polishing action. As an example, in this example, about 200 mL/min of water is supplied. Ultra-pure water may also be used. Instead of water, an alkaline solution and other solutions may be used.

The wafer 104 as the polishing object is rotated by the topring 101 through its drive shaft 108 while being pressed on top of the fixed-abrasive polishing tool 115 with an intervening elastic mat 102. On the other hand, the polishing table 56 (57) affixed with the fixed-abrasive polishing tool 115 is independently rotated, and polishing action is provided by the sliding action of the fixed-abrasive polishing tool in contact with the surface of the wafer 104 to be polished.

The finish process that follows is the buffing process performed by using pure water and soft polishing pad to carry out cleaning.

Next, a specific example is given of affixing the fixed-abrasive polishing tool to a fixation disk by a clamping device.

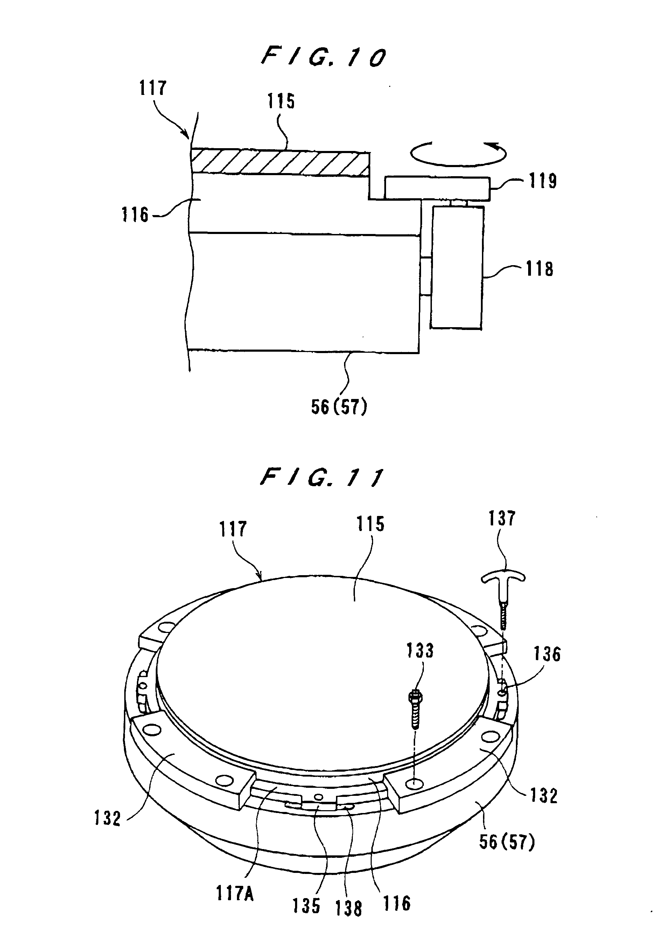

FIG. 10 shows a clamping method of affixing the fixed-abrasive polishing tool to the fixation disk. The fixed-abrasive polishing tool 115 is bonded to a metal disk 116 of aluminum metal and the like to comprise the fixed-abrasive polishing unit 117. The polishing table 56 (57) is provided with a clamping device 118, and the movable section 119 of the clamping device 118 holds the outer periphery of the fixed-abrasive polishing unit 117. Therefore, by opening the movable section 119 and placing the fixed-abrasive polishing unit 117 with bonded fixed-abrasive polishing tool 115 on the polishing table 56 (57) and then closing the movable section 119, the fixed-abrasive polishing unit 117'is fixed to the polishing table 56 (57) by means of a spring mechanism of the movable section. Also, by rotating the movable section 119 from an open position to a closed position, the fixed-abrasive polishing unit 117 can be detached from the polishing table 56 (57).

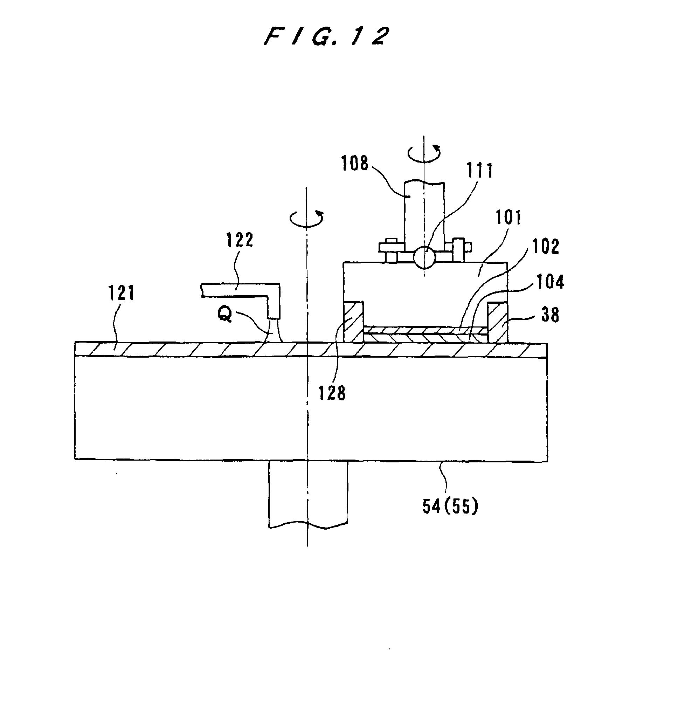

FIG. 11 shows another method of affixing the fixed-abrasive polishing tool to the fixation disk. The fixed-abrasive polishing tool 115 is fixed by the metal disk 116 with a brim and made of aluminum and the like to comprise the fixed-abrasive polishing unit 117. The brim section 117A of the fixed-abrasive polishing unit 117 is fixed by bolting the clamps 132 to the polishing table 56 (57). As shown in the drawing, clamp 132 having an arc-shaped structure of relatively wide width is used, and the angle of the arc to the center of both ends is set to 44 degrees, and the brim section 117A of the fixed-abrasive polishing unit 117 is clamped to the polishing table 56 (57) using two bolts 133. Therefore, detaching of the fixed-abrasive polishing unit 117 to and from the polishing table 56 (57) can be carried out easily by undoing the bolts 133. The reason for using such a relatively wide brimmed clamp is to avoid deforming the abrading surface of the fixed-abrasive polishing tool 115 that can be caused by clamping the outer periphery of the fixed-abrasive polishing unit 117 to the polishing table 56 (57).

Also, a total of four protruded section 135 are provided on the outer periphery of the brim section 117A of the metal disk comprising the fixed-abrasive polishing unit 117. The protruded sections 135 have screw holes 136 so that hanging bolt or push bolt 137 can be coupled. Because the fixed-abrasive polishing unit 117 is fairly heavy so that a hanging bolt 137 is provided to facilitate handling of the fixed-abrasive polishing unit 117 when exchanging the unit. And, the screw holes 136 are provided for inserting the push bolts 137 to detach the fixed-abrasive polishing unit 117 fixed to the polishing table 56 (57). That is, when the fixed-abrasive polishing unit 117 is to be detached from intimately attached polishing table 56 (57), the push bolt 137 is inserted into the screw hole 136 and rotated, thereby the tip of the push bolt 137 touches the back surface of the fixation disk and when it is further rotated, the fixed-abrasive polishing unit 117 can be detached from the polishing table 56 (57). A groove 138 is provided to correspond to the location of the screw hole 136 of the polishing table 56 (57). The groove 138 has a role for accommodating the tip of the hanging bolt or push bolt 137.

In this embodiment, four each of the clamps 132 and protruded section 135 are provided, but considering the service conditions such as pressing pressure, clamp may be made in a ring shape and the entire periphery of the fixed-abrasive polishing tool may be fixated. Also the number of protruded sections may also be adjusted suitably by considering the weight of the fixed-abrasive polishing tool and the tightly of fixation to the fixation disk. The material of the metal disk for bonding the fixed-abrasive polishing tool may include, in addition to aluminum materials, stainless steels and titanium materials may also be used, for example, by considering corrosion resistance characteristics.

FIG. 12 shows a schematic diagram of an example of the polishing apparatus based on slurry.

The apparatus is provided with a polishing table 54 (55) bonded with a polishing pad 121 made of a thermoplastic resin such as ABS resin and a topring 101 for holding a polishing object such as a semiconductor wafer 104. The polishing surface of the wafer 104 is processed to be polished by rotating both of topring and table over the surface of the polishing pad 121, while it is being pressed against the polishing pad 121 by the topring 101. A large volume of slurry Q is supplied on the polishing pad 121 from the slurry supply line 122. The polishing surface of the wafer104 is processed by the sliding action while it is being pressed against the polishing pad 121 having a slurry containing a large amount of abrasive particles as described above. Topring 101 is freely tiltably held on the rotation shaft 108 by way of a ball bearing 111, and topring 101 is rotated at a given speed as the rotation shaft 108 is driven. The wafer 104 is held within the guide ring 128 disposed around the outer periphery of the topring, and is pressed against the polishing pad 121 by the topring 101 through the elastic film 102. Here, because the polishing pad is made of a thermoplastic resin such as ABS resin or MBS resin, soft polishing is enabled that does not create scratches caused by a rise in the interface temperature during the sliding motion. Also, by using a resin containing elastic elements within the resin, it is possible to provide superior polishing action that produces stiff action macroscopically but produces soft action microscopically.

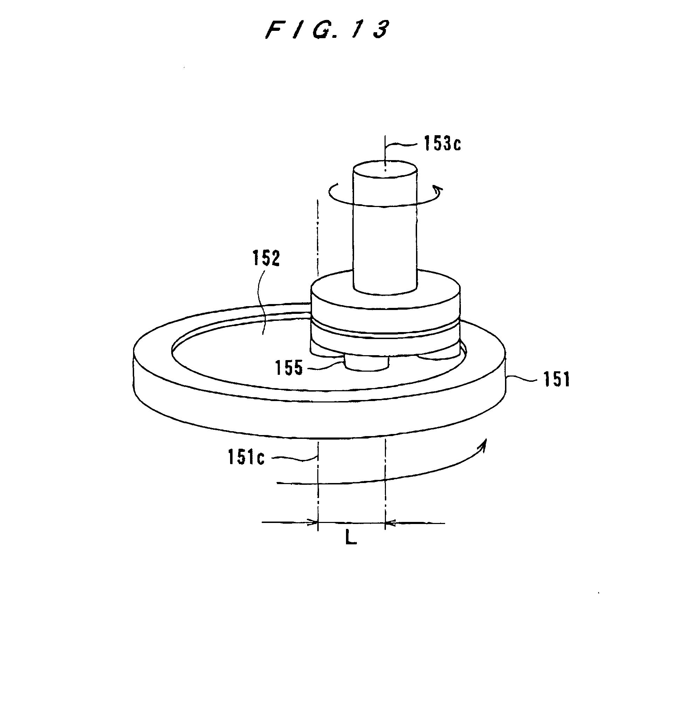

FIG. 13 shows another polishing apparatus of the present invention. In this polishing apparatus, a semiconductor wafer 152 as the polishing object is held in a rotating holding section 151, and a fixed-abrasive polishing tool of a pellet shape that rotates in a similar manner is made to be in sliding contact therewith. The pellet-shaped fixed-abrasive polishing tool 155 has a diameter of 20 mm and a thickness of 5 mm, for example, and four such tools are attached to the rotating holding jig 153. The holding jig 153 rotates about its axis 153c, and polishing action is produced by pressing the fixed-abrasive polishing tools 155 on the surface of the semiconductor wafer 152 as the polishing object and sliding the polishing surface of the fixed-abrasive polishing tools 155 over the surface of the semiconductor wafer 152. Here, the axis 153c of the holding jig 153c of the fixed-abrasive polishing tools is offset by a distance L with respect to the center 151c of the semiconductor wafer 152 as the polishing object so as to polish the entire surface of the semiconductor wafer as the polishing object. In this embodiment, the polishing object of about 150 mm or 200 mm is targeted and the amount of offset is about 35 mm.

Next, an outline of an example of the polishing conditions of this polishing apparatus will be explained. The rotational speed of semiconductor wafer as the polishing object is 100 min⁻¹, and the rotational speed of the fixed-abrasive polishing tool is 25 min⁻¹. The planar wafer pressure is 390 g/cm². In the case of polishing test using a resin pellet, about 3 cc of a slurry containing cerium oxide (containing surface-active agent) is supplied. In the case of fixed-abrasive pellets, about 3 cc of a pure water (containing surface-active agent) is supplied similarly.

In summary, the use of a thermoplastic resin or a resin having elastic elements in a fixed-abrasive polishing tool or a polishing pad, high quality polishing is enabled by producing superior flatness and less scratches (damage).

It would be noted that "fixed-abrasive polishing tool" may be also referred to as "bonded-abrasive polishing tool". The bonded-abrasive polishing tool comprises mixture of abrading particles and resin material, which are formed into a certain shape, so that abrading particles are bonded by resin matrix, and fixedly distributed within a resin matrix.

Although certain preferred embodiments of the present invention have been shown and described in detail, it should be understood that various changes and modifications may be made therein without departing from the scope of the appended claims.

## Claims

1. A polishing tool for polishing an object, wherein the polishing tool is comprised primarily by a thermoplastic resin.

2. A polishing tool according to claim 1, wherein the polishing tool is a fixed-abrasive polishing tool that contains abrading particles within the tool.

3. A polishing tool according to claim 1, wherein the polishing tool is a non-fixed-abrasive polishing pad.

4. A polishing tool according to claim 2, wherein the abrading particles include cerium oxide (CeO₂), alumina (Al₂O₃), silicon carbide (SiC), silicon dioxide (SiO₂), zirconia (ZrO₂), iron oxides (FeO, Fe₃O₄), manganese oxide (MnO₂, Mn₂O₃), magnesium oxide (MgO), calcium oxide (CaO), barium oxide (BaO), zinc oxide (ZnO), barium carbonate (BaCO₃), calcium carbonate (CaCO₃), diamond (C), or a composite material comprised by those recited above.

5. A polishing tool according to claim 1, wherein the polishing tool is formed by injection molding to charge a feed material under pressure into a mold of a specific shape.

6. A polishing tool according to claim 1, wherein a material comprising the polishing tool further comprises an interface activation agent.

7. A polishing tool according to claim 1, wherein a material comprising the polishing tool further comprises a hydrophilic substance or said material is modified by adding the hydrophilic substance.

8. A fixed-abrasive polishing tool for polishing an object, said polishing tool comprising:
abrading particles; and
a resin for binding said abrading particles in a matrix of said resin, wherein said resin comprises thermoplastic resin.

9. A fixed-abrasive polishing tool according to claim 8, wherein the abrading particles include cerium oxide (CeO₂), alumina (Al₂O₃), silicon carbide (SiC), silicon dioxide (SiO₂), zirconia (ZrO₂), iron oxides (FeO, Fe₃O₄), manganese oxide (MnO₂, Mn₂O₃), magnesium oxide (MgO), calcium oxide (CaO), barium oxide (BaO), zinc oxide (ZnO), barium carbonate (BaCO₃), calcium carbonate (CaCO₃), diamond (C), or a composite material comprised by those recited above.

10. A fixed-abrasive polishing tool according to claim 8, wherein a porosity is formed in said polishing tool.

11. A fixed-abrasive polishing tool according to claim 10, wherein a range of composition of fixed-abrasives (percentages of abrading particles (Vg), binder (Vb) and air porosity (Vp)) in volume percent (vol%) are: 10 %< abrading particles (Vg)<50 %, 30 %< binder (Vb) <80 %, and 0 %< air porosity (Vp) <40 %.

12. A method for making a fixed-abrasive polishing tool comprising:
using abrading particles and a thermoplastic resin as raw materials;
filling a forming fixture with a mixture of abrading particles and the thermoplastic resin into a mold; and
forming the fixed-abrasive polishing tool.

13. A method according to claim 12, wherein said forming is performed by heating-cooling the mixture and/or pressing the mixture.

14. A method according to claim 12, wherein said mixing of the abrading particles and the thermoplastic resin is carried out prior to or during filling or after filling a forming fixture with the raw materials.

15. A method for making a fixed-abrasive polishing tool, said method comprising:
mixing powdery abrading particles or a slurry and raw materials of the thermoplastic resin to form a dispersion liquid;
polymerizing or manufacturing the thermoplastic resin; and
making a mixture containing the polymerized thermoplastic resin and the abrading particles in the dispersion liquid during the step of polymerizing or manufacturing the thermoplastic resin.

16. A method according to claim 15, said method further comprising:
performing a mist drying step of said polymerized mixture.

17. A method according to claim 16, wherein said mist drying step comprising a spray drying step.

18. A method according to claim 16, wherein said mixture is formed with particles by the mist drying step and a diameter of the particles is in a range of 1∼500µm.

19. A method for making a fixed-abrasive polishing tool comprising:
mixing abrading particles and a resin in a liquid;
drying said mixed liquid to obtain dried mixed material; and
forming said dried mixed material into the fixed-abrasive polishing tool.

20. A method according to claim 19, wherein said abrading particles are provided in a state of slurry.

21. A method according to claim 19, wherein said resin is provided in a state of powder and mixed with abrading particles in water or a solvent.

22. A method according to claim 19, wherein said resin is provided in a liquid state where the resin is dispersed or dissolved in water or a solvent.

23. A method according to claim 19, wherein said drying step comprises a mist drying step.

24. A method according to claim 23, wherein said mist drying step is performed by a spray dryer.

25. A method according to claim 19, wherein said polishing tool is formed by filling the said mixed powder into a mold.

26. A method according to claim 19, wherein pulverizing is performed to obtain a powder in a range of 1-500 µm during or after drying said mixed liquid.

27. A method for making a fixed-abrasive polishing tool comprising:
mixing abrading particles and a liquid resin to form a mixed liquid;
drying and comminuting said mixed liquid to obtain dried mixed material; and
forming said dried mixed material into the fixed-abrasive polishing tool.

28. A method according to claim 27, wherein abrading particles are provided as a powder or dried slurry.

29. A method according to claim 28, wherein said drying step of slurry comprises a spray drying step.

30. A method for making a fixed-abrasive polishing tool comprising:
mixing powder of abrading particles and a powder of resin in a liquid to form a mixed liquid;
drying and comminuting said mixed liquid to obtain dried mixed material; and
forming said dried mixed material into the fixed-abrasive polishing tool.

31. A method according to claim 30, wherein said liquid comprises water or a solvent.

32. A method according to claim 31, wherein said powder of abrading particles is obtained by drying slurry.

33. A method according to claim 32, wherein said drying step of slurry comprises a spray drying step.

34. A method for making a fixed-abrasive polishing tool comprising:
mixing slurry containing abrasive particles and a liquid resin to form a mixed liquid;
drying said mixed liquid to obtain dried mixed material; and
forming said dried mixed material into the fixed-abrasive polishing tool.

35. A method according to claim 34, wherein said forming is performed by molding said dried mixed material into a mold.

36. A method according to claim 34, wherein said drying step comprises a mist drying step.

37. A method according to claim 34, wherein said drying step comprises a spray drying step.

38. A polishing apparatus for polishing a semiconductor wafer, comprising:
a topring for holding the wafer; and
a polishing tool, said polishing tool comprised primarily by a thermoplastic resin.

39. A polishing apparatus according to claim 38, wherein said semiconductor wafer has patterns comprised by high portions and low portions.

40. A polishing apparatus for polishing a semiconductor wafer, comprising:
a topring for holding the wafer; and
a fixed-abrasive polishing tool, said polishing tool comprising abrading particles and a resin for binding said abrading particles in a matrix of said resin, said resin comprises thermoplastic resin.

41. A polishing apparatus according to claim 40, wherein a range of composition of fixed-abrasive polishing tool (percentages of abrading particles (Vg), binder (Vb) and air porosity (Vp)) in volume percent (vol%) are: 10 %< abrading particles (Vg)<50 %, 30 %< binder (Vb) <80 %, and 0 %< air porosity (Vp) <40 %.

42. A polishing apparatus according to claim 40, wherein said semiconductor wafer has patterns comprised by high portions and low portions.

43. A polishing apparatus according to claim 40, further comprising: a dresser for dressing a polishing surface of said fixed-abrasive polishing tool.

44. A polishing apparatus according to claim 40, wherein said fixed-abrasive polishing tool is mounted on a base.

45. A polishing apparatus according to claim 44, wherein a polishing tool comprised by said fixed-abrasive polishing tool and said base is mounted detachably on a polishing table.

46. A polishing apparatus according to claim 45, wherein said polishing tool is fixed to said polishing table by clamps.

47. A polishing apparatus for polishing a semiconductor wafer, comprising:
at least one topring for holding the wafer; and
at least two polishing tables providing polishing surfaces respectively, wherein one of said polishing table having a fixed-abrasive polishing tool, said polishing tool comprising abrading particles and a thermoplastic resin for binding said abrading particles.

48. A method of polishing a substrate comprising:
polishing the substrate firstly by a fixed-abrasive polishing tool, said polishing tool comprising abrading particles and a thermoplastic resin for binding said abrading particles; and
finishing the substrate secondly by a finishing pad.

49. A method according to claim 48, wherein said first polishing is performed by supplying liquid not containing abrading particles.

50. A method according to claim 48, wherein said first polishing is performed by supplying water containing additive agent.

51. A method according to claim 48, wherein said finishing step is performed by supplying water.
